# EUROPEAN PATENT APPLICATION

(11) **EP 4 621 779 A1**
(43) Date of publication of application: **24.09.2025**
(21) Application number: 24165497.9
(22) Date of filing: 22.03.2024
(51) Int. Cl.: G11C 7/22, G11C 11/41, G11C 29/02, G11C 29/12

(54) **APPARATUS FOR CRITICAL PATH DETERMINATION**

(71) Applicant: NXP B.V., 5656 AG Eindhoven (NL)
(72) Inventor: ZANGI, Uzi, 5656 AG Eindhoven (NL); HADAS, Tzach, 5656 AG Eindhoven (NL); DAYAG, Noga, 5656 AG Eindhoven (NL); DADON, Israel, 5656 AG Eindhoven (NL)
(74) Representative: Miles, John Richard

(57) **Abstract**

An apparatus comprising:
a SRAM element comprising a clock input, an address input, an SRAM output, and a first and second address space, wherein a clock signal causes the SRAM element to output the logic value stored in a designated address space; a logic arrangement coupled to the SRAM output; and a feedback path configured to receive an output of the logic arrangement and provide a feedback clock and address signal; and
in an oscillation mode, a one is stored in the first address space and a zero in the second address space, and the feedback path provides the output of the logic cell arrangement to the address input and the feedback clock signal to trigger the output of the logic value stored in the currently designated address space and thereby the feedback path, the SRAM element and the logic cell arrangement form an oscillation loop.

## Description

### Field

The present disclosure relates to an apparatus for forming an oscillation loop including a static random access memory, SRAM, element.

### Background

The efficient operation of devices including SRAM elements may require the determination of critical paths that introduce the longest time delays between components. One method for determining a critical path time delay includes the establishment of an oscillation loop. However, the measurement of the critical path time delay is a challenge.

### Summary

According to a first aspect of the present disclosure there is provided an apparatus comprising:
a static random access memory, SRAM, element comprising a clock input configured to receive a clock signal and an address input configured to receive an address signal, and an SRAM output configured to provide the output of the SRAM element, wherein the address signal comprising logic zero designates a first address space and the address signal comprising logic one designates a second address space in the SRAM element, wherein each address space is configured to store at least a logic value, wherein one of a transition or logic level of the clock signal received at the clock input is configured to cause the SRAM element to provide, to the SRAM output, the at least logic value stored in the address space currently designated by the address signal;
a logic cell arrangement comprising a plurality of logic cells coupled to the SRAM output for coupling the SRAM output to a register; and
a feedback path configured to receive an output of the logic cell arrangement and, based on the output of the logic cell arrangement, provide a feedback clock signal as the clock signal to the clock input and a feedback address signal as the address signal to the address input of the SRAM element; and
wherein the apparatus, in an oscillation mode, is configured to store in the first address space a logic one and in the second address space a logic zero, and the feedback path is configured to provide the output of the logic cell arrangement as the address signal and provide, at a predetermined time after a transition of the output of the logic cell arrangement, the feedback clock signal to trigger the output, by the SRAM element, of the logic value stored in the address space currently designated by the address signal and thereby the feedback path, the SRAM element and the logic cell arrangement form an oscillation loop.

In one or more embodiments, the predetermined time is based on a minimum pulse width of the SRAM element.

In one or more embodiments, the predetermined time is based on a minimum time for the SRAM element to output the content of one of the address spaces following receipt of the address signal designating said one of the address spaces.

In one or more embodiments, the apparatus is configured to operate in a normal mode and the oscillation mode, wherein in the normal mode, the feedback path is disconnected from the address input and the clock input or inactive.

In one or more examples, the apparatus is switchable such that address input is configured to receive either the feedback address signal as the address signal at the address input or an operational address signal as the address signal at the address input.

In one or more examples, the apparatus is switchable such that clock input is configured to receive either the feedback clock signal as the clock signal at the clock input or an operational clock signal as the clock signal at the clock input. In one or more embodiments, the feedback path is coupled to the address input via a first multiplexer which also receives a first alternate input, and the feedback path is coupled to the clock input via a second multiplexer which also receives a second alternate input and wherein the first multiplexer and the second multiplexer, in the oscillation mode, couple the feedback path to the address input and the clock input and, in the normal mode connect the first alternate input and the second alternate input to the address input and the clock input respectively.

In one or more embodiments, in the normal mode after operating in the oscillation mode, the apparatus is configured to provide for reprogramming of the first address space and the second address space.

In one or more embodiments, the feedback path comprises:
a clock signal generating element configured to receive the output of the logic cell arrangement, delay the output of the logic cell arrangement to generate a delayed output, and provide the delayed output to the clock input.

In one or more examples, the clock signal generating element is configured to generate, based on receipt of a transition in logic level of the output of the logic cell arrangement, a pulse having a pulse width greater than or equal to a minimum pulse width of the SRAM element.

In one or more examples, the clock signal generating element is configured to delay the output of the pulse by a time greater than or equal to a minimum time for the SRAM element to output the contents of one of the address spaces following receipt of the address signal designating said one of the address spaces.

In one or more embodiments, the clock signal generating element comprises an XOR logic element configured to receive:
the output of the logic cell arrangement at a first terminal; and
a delayed version of the output of the logic cell arrangement delayed by a first delay element for a time greater than or equal to a minimum pulse width of the SRAM element; and
a second delay element configured to receive the output of the XOR logic element and introduce a further delay greater than or equal to a minimum time for the SRAM element to output the contents of one of the address spaces following receipt of the address signal designating said one of the address spaces.

In one or more embodiments, the feedback path provides a connection between the output of the logic cell arrangement and the address input.

In one or more embodiments, the feedback path includes a programmable delay element configured to delay the output of the logic cell arrangement.

In one or more embodiments, the apparatus includes a frequency measurement element to measure the frequency of an oscillating signal generated in the oscillation loop in the oscillation mode.

In one or more embodiments, the frequency measurement element is configured to measure the frequency of the oscillating signal in the oscillation loop without any delay introduced by the programmable delay element and measure the frequency of the oscillating signal in the oscillation loop with a set delay introduced by the programmable delay element that causes the frequency to halve, wherein a critical path delay time, representing the time delay between the clock signal being applied at the clock input and the resultant output of the SRAM element propagating through the logic cell arrangement, is based on the set delay.

According to a second aspect of the disclosure, we provide a static random access memory module including the apparatus of any preceding claim.

According to a third aspect of the disclosure, we provide a method of providing an oscillation loop for a static random access memory, SRAM, element comprising a clock input configured to receive a clock signal and an address input configured to receive an address signal, wherein a logic zero address signal designates a first address space and a logic one address signal designates a second address space in the SRAM element, wherein each address space is configured to store at least a logic value, wherein one of a transition or logic level of the clock signal received at the clock input is configured to cause the SRAM element to provide, to an SRAM output, the logic value stored in the address space currently designated by the address signal; and a logic cell arrangement comprising a plurality of logic cells coupled to the SRAM output for coupling the SRAM output to a register; the method comprising:
storing in the first address space a logic one;
storing in the second address space a logic zero;
providing, by a feedback path, the output of the logic cell arrangement as the address signal to the address input; and
providing, by the feedback path, at a predetermined time after a transition of the output of the logic cell arrangement, the feedback clock signal to trigger the output, by the SRAM element, of the logic value stored in the address space currently designated by the address signal to thereby provide an oscillation loop through the feedback path, the SRAM element and the logic cell arrangement.

In one or more embodiments, the method comprises providing the oscillation loop in an oscillation mode and at other times, operating in a normal mode in which the feedback path does not provide the output of the logic cell arrangement as the address signal to the address input and does not provide the output of the logic cell arrangement to trigger the output, by the SRAM element of the logic value stored in the address space currently designated by the address signal.

In one or more examples, the method comprises, based on receipt of a transition in logic level of the output of the logic cell arrangement, generating a pulse having a pulse width greater than or equal to a minimum pulse width of the SRAM element; delaying the output of the pulse by a time greater than or equal to a minimum time for the SRAM element to output the contents of one of the address spaces following receipt of the address signal designating said one of the address spaces; and wherein said delayed output of the pulse is provided to the clock input.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Figure 1 shows an example embodiment of an SRAM element, a combinational logic cell arrangement and a feedback path;
Figure 2 shows an example embodiment of circuitry of the feedback path;
Figure 3 shows an example timing diagram; and
Figure 4 shows a flowchart illustrating an example method.

### Detailed Description

The present disclosure relates to an apparatus for the determination of a critical path measurement or time delay through and between an element of Static Random Access Memory, SRAM, and a subsequent element, which may comprise a register.

Many different battery-operated systems require an ultra-low power chip solution in order to extend their battery lifetime. One of the ways to improve the power consumption is to lower the operating voltage and thereby reduce the active power by a square of the voltage reduction.

One method to reduce the operating voltage is to adjust the operating voltage based on the chip performance and environmental conditions. This method requires us to identity at the chip design stage the critical (longest) paths and to measure their time delay accurately on each different chip. With this information, different sensors can use the critical path delay time in order to define the optimal operating voltage or take other action.

In order that a device which is designed for the typical case will work also at different corners of the process there is a need to measure very accurately the timing of the critical path of the design, termed herein the critical path delay time. The critical path may comprise the longest electrical path between two elements, wherein at least one of the elements comprises an SRAM element and the other may comprise one or more of a flip-flop or a register.

The examples of the present disclosure relate to determination of a critical path delay time between an input to an SRAM module and an output of a logic arrangement coupled to an output of the SRAM module. Examples of the present disclosure allow for the SRAM's access time to be measured. The SRAM access time may be large portion of the overall critical path delay time. Those skilled in the art are free to determine how the critical path delay time determined by the disclosed arrangement is used in the fabrication and/or operation of the SRAM.

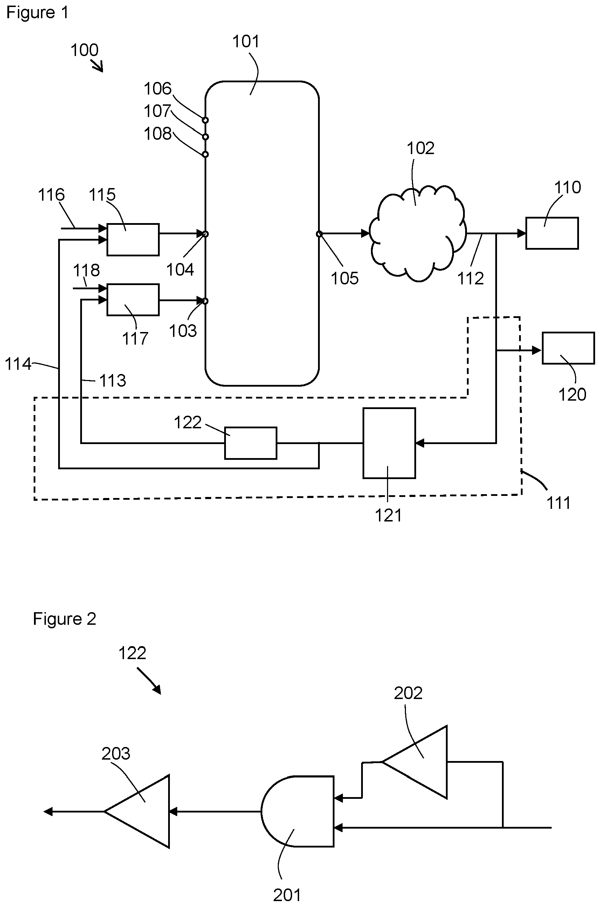

Figure 1 shows an example apparatus 100 comprising an SRAM element 101. The principle of operation of the example is to create an oscillation loop through the SRAM element 101 and the connected logic cell arrangement 102. Changes in logic value propagate through the logic elements and are fed back to the SRAM element 101 to continue the oscillation once again. The apparatus 100 may be configured to determine an oscillation frequency. The critical path delay time is derived from the oscillation frequency and, in the present examples, the critical path delay time includes a SRAM read delay (from provision of a clock signal that initiates a read of the SRAM element to data being provided to an output).

It will be appreciated that SRAM elements 101 or "registers" are sequential elements which require a clock signal to propagate the data. Therefore, it is a challenge where SRAM elements 101 are present to provide the oscillation loop. In the examples that follow we disclose a way to provide the oscillation loop going through the SRAM read cycle by generating a clock signal and an address signal using the oscillation signal.

Thus, with reference to figure 1, the SRAM element 101 comprises a clock input 103 configured to receive a clock signal and an address input 104 configured to receive an address signal. The SRAM element 101 has an SRAM output 105 configured to provide the output of the SRAM element. The SRAM output 105 may comprise a D_out output (data output). The SRAM element 101 may further comprise a D_in input 106 (data input), a select input 107 (chip select input, for selecting one of several integrated circuits of the SRAM element) and a WE input 108 (Write Enable input).

The SRAM element 101 may be configured to store multiple values, such as logic values or words, in two or more "address spaces". The address signal provided to the address input 104 is configured to allow for a particular one of the two or more address spaces to be selected for output. In the present example, when the address signal comprising a logic zero, a first address space is selected by the SRAM element 101. When the address signal comprises a logic one, a second address space is selected by the SRAM element 101. In this example, the address signal may comprise either a logic zero or a logic one, although in other examples, the address signal may comprise a word. In examples where the address signal is said to comprise logic zero, the word may comprise 00000 (for a 5 bit word). Likewise, when the address signal is said to comprise logic one, the word may comprise 11111 (for a five bit word). Thus, in one or more examples, the address signal may comprise a single logic level or a plurality of the same logic level.

As will be familiar to those skilled in the art of SRAM elements 101, the SRAM element 101 is configured to provide its output (from the selected address space) in response to a transition of the clock signal, such as low to high, although other configurations are possible, such as high to low or during a logic level. Thus, in general, the SRAM element 101 is configured to, on one of a transition or logic level of the clock signal received at the clock input, provide, to the SRAM output 105, the at least logic value stored in the address space currently designated by the address signal.

The apparatus 100 further comprises the combinational logic cell arrangement 102 comprising a plurality of logic cells coupled to the SRAM output 105 for coupling the SRAM output 102 to a subsequent component, such as register 110.

A feedback path 111 is configured to receive an output 112 of the combinational logic cell arrangement 102. The feedback path 111 comprise circuitry configured to, based on the output of the combinational logic cell arrangement 112, provide a "feedback" clock signal (shown by output 113) as the clock signal to the clock input 103 and a "feedback" address signal (shown by output 114) as the address signal to the address input 104.

The apparatus 100 is configured to operate in a normal mode and an oscillation mode. In the oscillation mode, the feedback path 111 is active in providing the feedback clock signal and the feedback address signal to the corresponding clock input 103 and address input 104. In the normal mode, the feedback path is inactive and/or disconnected from the address input 104 and the clock input 103.

In the present example, the feedback path 111 and, in particular, the output 114 that provides the feedback address signal, is coupled to the address input 104 via a first multiplexer 115. The first multiplexer 115 also receives a first alternate input 116. Further, the feedback path 111 and, in particular, the output 113 that provides the feedback clock signal, is coupled to the clock input 103 via a second multiplexer 117. The second multiplexer 117 also receives a second alternate input 118. The first multiplexer 115 and the second multiplexer 117 are switchable or selectable between their inputs. Thus, the apparatus 100 is configured such that the first multiplexer 115 and the second multiplexer 117, in the oscillation mode, couple the feedback path 111 to the address input 104 (in particular, the output 114 that provides the feedback address signal) and the clock input 103 (in particular, the output 113 that provides the feedback clock signal). Further, the apparatus 100 is configured such that, in the normal mode, the first multiplexer 115 and the second multiplexer 117 connect the first alternate input 116 and the second alternate input 118 to the address input 104 and the clock input 103 respectively. The first and second alternate inputs 116, 118 may be considered as operational inputs. Thus, the feedback path 111 may be disconnected from the SRAM element 101 or made otherwise inactive. The first alternate input 116 and the second alternate input 118 provide the address signal and the clock signal for normal operation.

In whichever way the oscillation mode is provided, the apparatus 100, in the oscillation mode, is configured to store in the first address space a logic one (or a plurality of logic ones) and in the second address space a logic zero (or plurality of logic zeros), and the feedback path 111 is configured to provide the output of the combinational logic cell arrangement 112 as the feedback address signal and provide, at a predetermined time after a transition of the output of the combinational logic cell arrangement 102, the feedback clock signal to the clock input 103 to trigger the output, by the SRAM element 101, of the logic value stored in the address space currently designated by the address signal.

Thus, when the feedback address signal comprises logic zero, the first address space is selected, which causes, on subsequent provision of the clock signal, the output of a logic one, which was stored in the first address space. Likewise, when the feedback address signal comprises logic one, the second address space is selected, which causes, on subsequent provision of the clock signal, the output of a logic zero, which was stored in the second address space. Thereby, the feedback path 111, the SRAM element 101 and the combinational logic cell arrangement 102 form an oscillation loop. It will be appreciated that when the apparatus 100 returns to the normal mode, the first address space and the second address space can be reprogrammed to store whatever information is required of the SRAM element 101. However, in the oscillation mode, the first address space and the second address space are programmed with logic values such that the output of the logic cell arrangement 102 toggles between the values of the first and second address space such that the feedback address signal causes the output of the opposite logic level from the SRAM element 101.

The following table provides a further example of the programming of the address spaces of the SRAM element. The address spaces are shown in the rows of the table where each row includes the address for the address space and the content of the address space.

| Address | Content |
|---|---|
| 0x0000 | 0x0001 |
| 0x0001 | 0x0000 |
| 0x0002 | X |
| · | X |
| · | X |
| 0xFFFF | X |

Thus, the address space at the address 0x0000, which would be selected based on the feedback address signal comprising a logic zero, stores 0x0001, which provides a logic one when output by the SRAM element 101. Thus, in this example, the bit 0 of the data output 105 is coupled to the logic cell arrangement 102 such that it receives the logic one. Likewise, the address space at the address 0x0001, which would be selected based on the feedback address signal comprising a logic one, stores 0x0000, which provides a logic zero at the output 105 of the SRAM element 101. Thus, in this example, the bit 0 of the data output 105 is coupled to the logic cell arrangement 102 such that it receives the logic zero.

The SRAM element 101 may have operational limits. For example, each pulse or state transition of the clock signal may need to have a minimum predetermined width (i.e. length of time) to be recognized by the SRAM element 101. Such a parameter may be known as the minimum pulse width or MPW. Turning to a further operational limit, in some examples, the SRAM element 101 may be such that there is a delay selecting one of the address spaces and it being ready for output of the value stored therein. Thus, an address setup time may comprise the minimum time between when the SRAM element is initially able to output from a particular address space and receipt of the address signal selecting that particular address space. In one or more examples, the feedback path may be configured to accommodate the MPW and/or the address setup time when providing the oscillation loop in the oscillation mode.

Thus, the aforementioned predetermined time may be based on a minimum pulse width of the SRAM element and/or the address setup time.

Thus, a logic transition will propagate through the combinational logic cell arrangement 102 and will be received by the feedback path 111 at output 112. The feedback path 111 may accommodate for the MPW and address setup time (as will be described later) and a logic one provided as the feedback address signal will cause the output of a logic zero by the SRAM element 101 and a logic zero provided as the feedback address signal will cause the output of a logic one by the SRAM element 101, thereby continuing the propagation of the oscillation around the oscillation loop.

The apparatus 100 may include a frequency measurement element 120 to measure the frequency of the oscillation in the oscillation loop. As will be familiar to those skilled in the art, the critical path delay time can be determined based on the frequency.

The determination of the critical path delay time will now be described in more detail. The feedback path 111 may include a programmable delay element 121.

The programmable delay element 121 may be configured to delay the output 112 of the combinational logic cell arrangement 102. In particular, the programmable delay element 121 can thereby introduce a known delay into the oscillation loop created in the oscillation mode.

At a first time, the frequency measurement element 120 is configured to measure the frequency of the oscillating signal in the oscillation loop without any delay (or more generally a first known delay) introduced by the programmable delay element 121.

At a second time, the frequency measurement element 120 is configured to measure the frequency of the oscillating signal in the oscillation loop with a set delay (i.e. a second delay) introduced by the programmable delay element 121 that (e.g. changed until it) causes the frequency measured by the frequency measurement element 120 to halve. Thus, the programmable delay element 121 may be controlled to adjust the delay it introduces into the oscillation loop until it is determined by the frequency measurement element 120 that the frequency has halved (or comprises some other fraction in other examples) of the frequency determined at the first time. At this state the code of the delay of the programmable delay element 121 represent the delay of the measured path.

Thus, when the frequency of the oscillation in the oscillation loop is half what it was without the set delay, the set delay is equal to the critical path delay time through the SRAM element 101 and the logic cell arrangement 102.

Thus, the apparatus 100 is configured to determine the critical path delay time, representing the time delay between the clock signal being applied at the clock input 103 and the resultant output of the SRAM element propagating through the combinational logic cell arrangement 102, based on the set delay introduced by the programmable delay element 121 when the frequency measurement element 120 determines a condition (e.g. halving) has been met based on the oscillation frequency.

With reference to the example shown in Figures 1 and 2, the feedback path 111 comprises a clock signal generating element 122 configured to receive the output 112 of the combinational logic cell arrangement 102 (such as via the programmable delay element 121), delay the output of the combinational logic cell arrangement 102 to generate a delayed output, and provide the delayed output to the clock input 103. The delayed output is generated to provide the aforementioned predetermined time based on a minimum pulse width of the SRAM element and the address setup time. The feedback path 111, in the present example, is configured to provide the output of the programmable delay element 121 and therefore the output of the logic arrangement 102 directly to the address input 104.

Figure 2 shows one example of the circuitry that may provide the function of the clock signal generating element 122. The clock signal generating element 122 comprises an "exclusive or" XOR logic element 201 configured to receive, at a first terminal, the output of the combinational logic cell arrangement 102 (such as via the programmable delay element 121), and, at a second terminal, a delayed version of the output of the combinational logic cell arrangement delayed by a first delay element 202. The first delay element 202, in the present example, receives the output of the combinational logic cell arrangement 102, which may be via the programmable delay element 121. The delay provided by the first delay element 202 is for a time greater than or equal to the minimum pulse width of the SRAM element 101.

The output of the XOR logic element 122 is connected to a second delay element 203. The second delay element 203 receives the output of the XOR logic element and introduces a further delay greater than or equal to the address setup time. As mentioned above, the address setup time comprises a minimum time for the SRAM element 101 to output the contents of one of the address spaces following receipt of the address signal designating said one of the address spaces. Thus, it represents the time to prepare an address space for output of its contents.

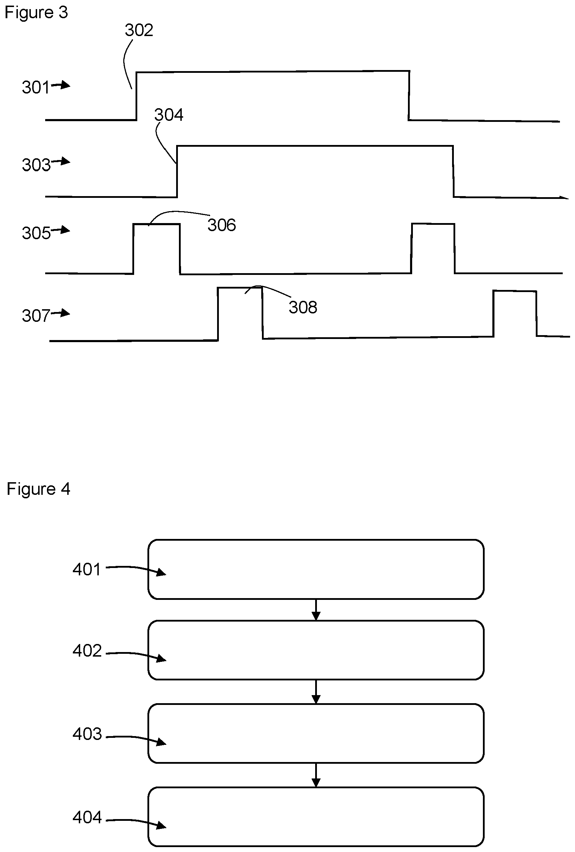

Figure 3 shows a timing diagram illustrating the action of the clock signal generating element 122. Trace 301 shows the output from the combinational logic cell arrangement 102 received via the programmable delay element 121. The trace 301 includes a low to high transition 302. Thus, the signal of the form shown in trace 301 is received by the XOR logic element at the first input and is received by the first delay element 202. Trace 303 shows the output of the first delay element 202. Thus, the transition 302 is delayed and is shown as transition 304. The output of the XOR logic element 122 is shown in trace 305. Thus, the width of the pulse 306 created by the first delay element 202 in combination with the XOR logic element 122 can be controlled to meet the MPW requirement for the SRAM element 101 by the time delay introduced by the first delay element 202.

The output of the XOR logic element 122 is provided to the second delay element 203 and trace 307 shows the output of the second delay element 203. The pulse 306 has been delayed to a later time and is shown as pulse 308. The pulse 308 and the rest of trace 307 is provided as the feedback clock signal to the clock input 103.

As mentioned, the output from the combinational logic cell arrangement 102, via the programmable delay element 121, is provided as the feedback address signal to the address input 104. In the present example, the output from the combinational logic cell arrangement 102, received via the programmable delay element 121, is provided un-delayed relative to the feedback clock signal, to the address input 104.

Thus, in general, the clock signal generating element 122 is configured to generate pulses of at least the MPW based on a transition 302 in the output from the combinational logic cell arrangement 102 or the programmable delay element 121. The clock signal generating element 122 is further configured to provide those pulses to the clock input 103 (as the feedback clock signal) at at least an address setup time after the transition 302, or a signal based on the transition 302, is provided to the address input 104 (as the feedback address signal).

The apparatus 100 may be a part of a larger SRAM module. Thus, we also disclose a SRAM module comprising a plurality of said apparatus 100, which may be directly or indirectly connected together or unconnected.

With reference to the flowchart of figure 4, we also disclose a method of providing an oscillation loop for the static random access memory, SRAM, element 101 comprising the clock input 103 configured to receive the clock signal and the address input 104 configured to receive the address signal, wherein a logic zero address signal designates the first address space and a logic one address signal designates the second address space in the SRAM element 101, wherein each address space is configured to store at least a logic value, wherein one of a transition or logic level of the clock signal received at the clock input 103 is configured to cause the SRAM element to provide, to the SRAM output 105, the logic value stored in the address space currently designated by the address signal; and a combinational logic cell arrangement 102 comprising a plurality of logic cells coupled to the SRAM output for coupling the SRAM output to the register 110.

The method comprises:
storing 401 in the first address space a logic one;
storing 402 in the second address space a logic zero;
providing 403, by a feedback path, the output of the combinational logic cell arrangement as the address signal to the address input; and
providing 404, by the feedback path 111, at a predetermined time after a transition of the output of the combinational logic cell arrangement 102, the feedback clock signal to trigger the output, by the SRAM element 101, of the logic value stored in the address space currently designated by the address signal to thereby provide an oscillation loop through the feedback path 111, the SRAM element 101 and the combinational logic cell arrangement 102.

As mentioned, such a method of providing the oscillation loop is done so in an oscillation mode. At other times, the apparatus 100 may be configured to operate in a normal mode in which the feedback path 111 does not provide the output of the combinational logic cell arrangement as the address signal to the address input and does not provide the output of the combinational logic cell arrangement to trigger the output, by the SRAM element of the logic value stored in the address space currently designated by the address signal. Instead, the clock input 103 and the address input 104 may be configured to receive signals other than those generated by the feedback path 111, such as to operate as a SRAM element 101 for storing information.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. An apparatus comprising:
a static random access memory, SRAM, element comprising a clock input configured to receive a clock signal and an address input configured to receive an address signal, and an SRAM output configured to provide the output of the SRAM element, wherein the address signal comprising logic zero designates a first address space and the address signal comprising logic one designates a second address space in the SRAM element, wherein each address space is configured to store at least a logic value, wherein one of a transition or logic level of the clock signal received at the clock input is configured to cause the SRAM element to provide, to the SRAM output, the at least logic value stored in the address space currently designated by the address signal;
a logic cell arrangement comprising a plurality of logic cells coupled to the SRAM output for coupling the SRAM output to a register; and
a feedback path configured to receive an output of the logic cell arrangement and, based on the output of the logic cell arrangement, provide a feedback clock signal as the clock signal to the clock input and a feedback address signal as the address signal to the address input of the SRAM element; and
wherein the apparatus, in an oscillation mode, is configured to store in the first address space a logic one and in the second address space a logic zero, and the feedback path is configured to provide the output of the logic cell arrangement as the address signal and provide, at a predetermined time after a transition of the output of the logic cell arrangement, the feedback clock signal to trigger the output, by the SRAM element, of the logic value stored in the address space currently designated by the address signal and thereby the feedback path, the SRAM element and the logic cell arrangement form an oscillation loop.

2. The apparatus of claim 1, wherein the predetermined time is based on a minimum pulse width of the SRAM element.

3. The apparatus of claim 1 or claim 2, wherein the predetermined time is based on a minimum time for the SRAM element to output the content of one of the address spaces following receipt of the address signal designating said one of the address spaces.

4. The apparatus of any preceding claim, wherein the apparatus is configured to operate in a normal mode and the oscillation mode, wherein in the normal mode, the feedback path is disconnected from the address input and the clock input or inactive.

5. The apparatus of claim 4, wherein the feedback path is coupled to the address input via a first multiplexer which also receives a first alternate input, and the feedback path is coupled to the clock input via a second multiplexer which also receives a second alternate input and wherein the first multiplexer and the second multiplexer, in the oscillation mode, couple the feedback path to the address input and the clock input and, in the normal mode connect the first alternate input and the second alternate input to the address input and the clock input respectively.

6. The apparatus of claim 4, wherein in the normal mode after operating in the oscillation mode, the apparatus is configured to provide for reprogramming of the first address space and the second address space.

7. The apparatus of any preceding claim wherein the feedback path comprises
a clock signal generating element configured to receive the output of the logic cell arrangement, delay the output of the logic cell arrangement to generate a delayed output, and provide the delayed output to the clock input.

8. The apparatus of claim 7 wherein the clock signal generating element comprises an XOR logic element configured to receive:
the output of the logic cell arrangement at a first terminal; and
a delayed version of the output of the logic cell arrangement delayed by a first delay element for a time greater than or equal to a minimum pulse width of the SRAM element; and
a second delay element configured to receive the output of the XOR logic element and introduce a further delay greater than or equal to a minimum time for the SRAM element to output the contents of one of the address spaces following receipt of the address signal designating said one of the address spaces.

9. The apparatus of claim 7, wherein the feedback path provides a connection between the output of the logic cell arrangement and the address input.

10. The apparatus of any preceding claim, wherein the feedback path includes a programmable delay element configured to delay the output of the logic cell arrangement.

11. The apparatus of any preceding claim, wherein the apparatus includes a frequency measurement element to measure the frequency of an oscillating signal generated in the oscillation loop in the oscillation mode.

12. The apparatus of claim 11, wherein the frequency measurement element is configured to measure the frequency of the oscillating signal in the oscillation loop without any delay introduced by the programmable delay element and measure the frequency of the oscillating signal in the oscillation loop with a set delay introduced by the programmable delay element that causes the frequency to halve, wherein a critical path delay time, representing the time delay between the clock signal being applied at the clock input and the resultant output of the SRAM element propagating through the logic cell arrangement, is based on the set delay.

13. A static random access memory module including the apparatus of any preceding claim.

14. A method of providing an oscillation loop for a static random access memory, SRAM, element comprising a clock input configured to receive a clock signal and an address input configured to receive an address signal, wherein a logic zero address signal designates a first address space and a logic one address signal designates a second address space in the SRAM element, wherein each address space is configured to store at least a logic value, wherein one of a transition or logic level of the clock signal received at the clock input is configured to cause the SRAM element to provide, to an SRAM output, the logic value stored in the address space currently designated by the address signal; and a logic cell arrangement comprising a plurality of logic cells coupled to the SRAM output for coupling the SRAM output to a register; the method comprising:
storing in the first address space a logic one;
storing in the second address space a logic zero;
providing, by a feedback path, the output of the logic cell arrangement as the address signal to the address input; and
providing, by the feedback path, at a predetermined time after a transition of the output of the logic cell arrangement, the feedback clock signal to trigger the output, by the SRAM element, of the logic value stored in the address space currently designated by the address signal to thereby provide an oscillation loop through the feedback path, the SRAM element and the logic cell arrangement.

15. The method of claim 14, wherein the method comprises providing the oscillation loop in an oscillation mode and at other times, operating in a normal mode in which the feedback path does not provide the output of the logic cell arrangement as the address signal to the address input and does not provide the output of the logic cell arrangement to trigger the output, by the SRAM element of the logic value stored in the address space currently designated by the address signal.

## Amended claims

### Amended claims in accordance with Rule 137(2) EPC.

1. An apparatus (100) comprising:
a static random access memory, SRAM, element (101) comprising a clock input (103) configured to receive a clock signal and an address input (104) configured to receive an address signal, and an SRAM output (105) configured to provide the output of the SRAM element, wherein the address signal comprising logic zero designates a first address space and the address signal comprising logic one designates a second address space in the SRAM element, wherein each address space is configured to store at least a logic value, wherein one of a transition or logic level of the clock signal received at the clock input (103) is configured to cause the SRAM element to provide, to the SRAM output, the at least logic value stored in the address space currently designated by the address signal;
a logic cell arrangement (102) comprising a plurality of logic cells coupled to the SRAM output (105) for coupling the SRAM output (105) to a register (110); and
a feedback path (111) configured to receive an output (112) of the logic cell arrangement (102) and, based on the output (112) of the logic cell arrangement (102), provide a feedback clock signal (113) as the clock signal to the clock input (103) and a feedback address signal (114) as the address signal to the address input (104) of the SRAM element (101); and
wherein the apparatus (100), in an oscillation mode, is configured to store in the first address space a logic one and in the second address space a logic zero, and the feedback path (111) is configured to provide the output of the logic cell arrangement (102) as the address signal and provide, at a predetermined time after a transition of the output of the logic cell arrangement (102), the feedback clock signal (113) to trigger the output (112), by the SRAM element (101), of the logic value stored in the address space currently designated by the address signal and thereby the feedback path (111), the SRAM element (101) and the logic cell arrangement (102) form an oscillation loop.

2. The apparatus (100) of claim 1, wherein the predetermined time is based on a minimum pulse width of the SRAM element (101).

3. The apparatus (100) of claim 1 or claim 2, wherein the predetermined time is based on a minimum time for the SRAM element (101) to output the content of one of the address spaces following receipt of the address signal designating said one of the address spaces.

4. The apparatus (100) of any preceding claim, wherein the apparatus (100) is configured to operate in a normal mode and the oscillation mode, wherein in the normal mode, the feedback path (111) is disconnected from the address input (104) and the clock input (103) or inactive.

5. The apparatus (100) of claim 4, wherein the feedback path is coupled to the address input (104) via a first multiplexer (115) which also receives a first alternate input (116), and the feedback path (111) is coupled to the clock input (103) via a second multiplexer (117) which also receives a second alternate input (118) and wherein the first multiplexer (115) and the second multiplexer (117), in the oscillation mode, couple the feedback path (111) to the address input (104) and the clock input (103) and, in the normal mode connect the first alternate input (116) and the second alternate input (118) to the address input (104) and the clock input (103) respectively.

6. The apparatus (100) of claim 4, wherein in the normal mode after operating in the oscillation mode, the apparatus (100) is configured to provide for reprogramming of the first address space and the second address space.

7. The apparatus (100) of any preceding claim wherein the feedback path (111) comprises
a clock signal generating element (122) configured to receive the output (112) of the logic cell arrangement (102), delay the output of the logic cell arrangement (102) to generate a delayed output, and provide the delayed output to the clock input (103).

8. The apparatus (100) of claim 7 wherein the clock signal generating element (122) comprises an XOR logic element (201) configured to receive:
the output (112) of the logic cell arrangement (102) at a first terminal; and
a delayed version of the output of the logic cell arrangement delayed by a first delay element (202) for a time greater than or equal to a minimum pulse width of the SRAM element (101); and
a second delay element (203) configured to receive the output of the XOR logic element and introduce a further delay greater than or equal to a minimum time for the SRAM element (101) to output the contents of one of the address spaces following receipt of the address signal designating said one of the address spaces.

9. The apparatus (100) of claim 7, wherein the feedback path (111) provides a connection between the output (112) of the logic cell arrangement (102) and the address input (104).

10. The apparatus (100) of any preceding claim, wherein the feedback path (111) includes a programmable delay element (121) configured to delay the output (112) of the logic cell arrangement (102).

11. The apparatus (100) of any preceding claim, wherein the apparatus (100) includes a frequency measurement element (120) to measure the frequency of an oscillating signal generated in the oscillation loop in the oscillation mode.

12. The apparatus (100) of claim 11 when dependent on claim 10, wherein the frequency measurement element (120) is configured to measure the frequency of the oscillating signal in the oscillation loop without any delay introduced by the programmable delay element (121) and measure the frequency of the oscillating signal in the oscillation loop with a set delay introduced by the programmable delay element (121) that causes the frequency to halve, wherein a critical path delay time, representing the time delay between the clock signal being applied at the clock input (103) and the resultant output of the SRAM element (101) propagating through the logic cell arrangement (102), is based on the set delay.

13. A static random access memory module including the apparatus (100) of any preceding claim.

14. A method of providing an oscillation loop for a static random access memory, SRAM, element comprising a clock input configured to receive a clock signal and an address input configured to receive an address signal, wherein a logic zero address signal designates a first address space and a logic one address signal designates a second address space in the SRAM element, wherein each address space is configured to store at least a logic value, wherein one of a transition or logic level of the clock signal received at the clock input is configured to cause the SRAM element to provide, to an SRAM output, the logic value stored in the address space currently designated by the address signal; and a logic cell arrangement comprising a plurality of logic cells coupled to the SRAM output for coupling the SRAM output to a register; the method comprising:
Storing (401) in the first address space a logic one;
storing (402)in the second address space a logic zero;
providing (403), by a feedback path, the output of the logic cell arrangement as the address signal to the address input; and
providing (404), by the feedback path, at a predetermined time after a transition of the output of the logic cell arrangement, the feedback clock signal to trigger the output, by the SRAM element, of the logic value stored in the address space currently designated by the address signal to thereby provide an oscillation loop through the feedback path, the SRAM element and the logic cell arrangement.

15. The method of claim 14, wherein the method comprises providing the oscillation loop in an oscillation mode and at other times, operating in a normal mode in which the feedback path does not provide the output of the logic cell arrangement as the address signal to the address input and does not provide the output of the logic cell arrangement to trigger the output, by the SRAM element of the logic value stored in the address space currently designated by the address signal.
